# EUROPEAN PATENT SPECIFICATION

(11) **EP 4 684 614 B1**
(45) Date of publication and mention of the grant of the patent: **29.04.2026**
(21) Application number: 24715846.2
(22) Date of filing: 22.03.2024
(51) Int. Cl.: H10N 30/01, H10N 30/20, H10N 30/30, H10N 30/076, H10N 30/082, G01C 19/5628, G01C 19/5621

(54) **METHOD FOR MANUFACTURING PIEZOELECTRIC MICROELECTROMECHANICAL DEVICE**
HERSTELLUNGSVERFAHREN FÜR EINE PIEZOELEKTRISCHE MIKROELEKTROMECHANISCHE VORRICHTUNG
PROCÉDÉ DE FABRICATION D'UN DISPOSITIF MICROÉLECTROMÉCANIQUE PIÉZOÉLECTRIQUE

(30) Priority: 23.03.2023 FI 20237058
(43) Date of publication of application: 28.01.2026
(73) Proprietor: Aalto University Foundation sr, 00076 Aalto (FI)
(72) Inventor: BESPALOVA, Kristina, 00076 Aalto (FI); GABRELIAN, Artem, 00076 Aalto (FI); PAULASTO-KRÖCKEL, Mervi, 00076 Aalto (FI); ROSS, Glenn, 00076 Aalto (FI); NIEMINEN, Tarmo, 00076 Aalto (FI)
(74) Representative: Laine IP Oy
(86) International application number: PCT/FI2024/050143
(87) International publication number: WO 2024/194533

(56) References cited:
- WO-A1-2022/226913
- CN-A- 113 364 423
- US-A1- 2010 045 141
- GABRELIAN ARTEM ET AL: "Unlocking the potential of piezoelectric films grown on vertical surfaces for inertial MEMS", MATERIALS TODAY COMMUNICATIONS, vol. 33, 21 September 2022 (2022-09-21), GB, pages 104522, XP093111841, ISSN: 2352-4928, DOI: 10.1016/j.mtcomm.2022.104522
- Ü SÖKMEN ET AL: "Evaluation of resonating Si cantilevers sputter-deposited with AlN piezoelectric thin films for mass sensing applications;Evaluation of resonating Si cantilevers sputter-deposited with AlN piezoelectric thin films for mass sensing applications", JOURNAL OF MICROMECHANICS AND MICROENGINEERING, INSTITUTE OF PHYSICS PUBLISHING, BRISTOL, GB, vol. 20, no. 6, 1 June 2010 (2010-06-01), pages 64007, XP020192935, ISSN: 0960-1317, DOI: 10.1088/0960-1317/20/6/064007
- SORDO GUIDO ET AL: "Study on the effectiveness of different electrode geometries for sputtered Aluminium Nitride-based MEMS energy harvesters", 2016 SYMPOSIUM ON DESIGN, TEST, INTEGRATION AND PACKAGING OF MEMS/MOEMS (DTIP), IEEE, 30 May 2016 (2016-05-30), pages 1 - 4, XP032925571, DOI: 10.1109/DTIP.2016.7514871

## Description

### FIELD

This disclosure relates to the field of microelectromechanical systems (MEMS) nanoelectromechanical systems (NEMS) and piezoelectric actuation. In general, the presented invention concerns microelectromechanical systems (MEMS). In particular, but not exclusively, the invention pertains to electromechanical transducers in the fields of inertial MEMS and energy scavenging.

### BACKGROUND

Three-dimensional motion (3D motion) indicates unhindered finite motion in x, y, and z-axis direction, where x, y-axis (lateral) is in the plane of the device, and z-axis is in the out-of-plane (vertical) direction. Compact actuators, that can implement full 3D motion on micro- and nanoscale, are complex to design and fabricate. Microelectromechanical systems (MEMS) that enable 3D sensing and actuation frequently combine several devices. Each of these devices performs motion in one direction only, therefore, such MEMS usually hold a large space on a chip. Attempts to create small-size coupled 3D-moving device lead to a growing cross-axis sensitivity between different channels or so-called "mechanical crosstalk. This disclosure presents an approach to fabricating MEMS/NEMS devices that allows for pure in-plane motion by having a piezoelectric transducer fabricated on the vertical surfaces of a MEMS/NEMS element(s).

Document A. Gabrelian, et al. "Unlocking the potential of piezoelectric films grown on vertical surfaces for intertial MEMS, Materials Today Communications 2022, 33, p.104522, describes simulations for a piezoelectric MEMS transducer.

Document Ü. Sökmen et al. "Evaluation of resonating Si cantilevers sputter deposited with AlN piezoelectric thin films for mass sensing applications" Journal of Micromechanics and Microengineering, Institute of Physics Publishing, Bristol, GB, vol. 20, no. 6, 1 June 2010 (2010-06-01), page 64007, XP020192935, ISSN: 0960-1317, DOI: 10.1088/0960-1317/6/064007, describes piezoelectric MEMS transducers.

Document S. Guido et al. "Study on the effectiveness of different electrode geometries for sputtered Aluminium Nitride-based MEMS energy harvesters", 2016 Symposium on design, test, integration and packaging of MEMS/MOEMS (DTIP), IEEE, 30 May 2016 (2016-05-30), pages 1-4, XP032925571, DOI: 10.1109/DTIP.2016.75714871, describes piezoelectric MEMS transducers.

Document CN113 364 423 A describes piezoelectric MEMS transducers.

### SUMMARY OF THE INVENTION

The invention is defined by the features of the independent claim. Some specific embodiments are defined in the dependent claims.

According to the present invention, there is provided a method for manufacturing a MEMS transducer according to claim 1.

### BRIEF DESCRIPTION OF THE DRAWINGS

FIG. 1 Illustration of the device performance. FIG. 1A illustrates concept of the device. FIG. 1B illustrates cantilever's motion when voltage is applied between top and bottom electrodes, and deformation of AlN under applied voltage.
FIG. 2A Illustration of the multiaxial MEMS device performance: 3D piezoactuator,
FIG. 2B Illustration of the multiaxial MEMS device performance: multiaxial energy harvester illustrating in-plane (x-y plane) and out-of-plane (y-z plane) direction harvesting.
FIG. 3 Designation of the main parts of the device on the schematic illustration of the structure. FIG 3A: The cantilever comprises a Si(111) n++ device layer, TiN top electrodes, a buried oxide layer BOX SiO2, a handle wafer, and a MOVPE grown AlN on sidewalls of the silicon cantilever. FIG 3B: Two cantilevers are shown separated by a silicon bridge area and cavity.
FIG. 4 SEM micrographs of the fabricated device. FIG. 4A depicts a released cantilever and FIG. 4B two released cantilevers.
FIG. 5A and FIG. 5B. Illustration of the fabrication line of the device and picture of the device area.

### EMBODIMENTS

Novel design that utilizes aluminum nitride AlN piezoelectric thin films deposited on vertical surfaces for lateral motion and sensing is a step towards emerging multi-axial MEMS. This work demonstrates the fabrication process and potential applications of the in-plane moving piezoactuator. The actuator is excited using the inverse piezoelectric effect of AlN thin film grown on the vertical surfaces of a Si cantilever. Lateral motion of the actuator is enabled when voltage is applied between the top and bottom electrodes of the device, which are highly doped Si and titanium nitride TiN thin film.

The development of a novel architecture for 3D motion in MEMS and nanoelectromechanical systems, NEMS, would open breaking prospects for a fabrication of state-of-the-art devices and technologies. Enhanced design not only brings opportunities for more accurate inertial sensing in autonomous vehicles or augmented and virtual reality AR/VR systems but also for new types of MEMS/NEMS. For example, multiaxial motion on the nanoscale introduces new approaches to nanoswitches of complex design, optical beam steering devices, and gyroscopes. Moreover, nanoscale 3D motion can play a pivotal role in addressing the issue of multifunctional nanomanipulators that move and configure nanosized particles, cells, and other biological objects. In addition, compact 3D MEMS would introduce novel inertial MEMS with superior accuracy and high functional density meaning large number of devices located on small surface area. For example, piezo half tuning fork MEMS gyroscope demonstrated in the work by Gabrelian et al., would require only 0.00846 mm² while other demonstrated gyroscopes with similar sensitivity occupy from 2 to 72 mm².

MEMS devices that employ piezoelectric effect for actuation (piezoactuators) have several strengths due to direct electromechanical coupling, small size, and small voltage that can be applied for driving. No high voltage drive or DC bias is required for the excitation of piezoactuators because an output signal is proportional to the change in stress. Moreover, piezoelectric-based MEMS, piezoMEMS, are less sensitive to the stiction, which is common for comb drive devices. Fabrication techniques for the out-of-plane moving piezoactuators have been thoroughly demonstrated previously, while the design for structures that implement 3D motion remains difficult to fulfill. One of the main challenges in the fabrication of a coupled 3D piezoMEMS device is the generation of the lateral motion. In-plane piezoactuator must have a piezoelectric layer with certain crystallographic orientation deposited on the vertical surfaces of a moving cantilever and a suitable electrical connection to this layer. The crystallographic orientation of the piezoelectric material must be chosen thus to maximize the piezoelectric effect capability. Twisting or tilting cannot be considered as a pure lateral motion, because in this case a vertical motion component still exists. Thus, design development for laterally driven piezoelectric-based actuators is becoming a pivotal link to fabrication of novel compact 3D piezoMEMS.

Aluminum nitride AlN is a well-known, lead-free, piezoelectric material. Using AlN thin films grown on vertical surfaces of Si cantilever one can get naturally bimorph and highly symmetrical structures, which can provide greater robustness and energy efficiency to the system. Laterally moving AlN-based actuator could have a small static amplitude, which can be utilized for nano-scale measurements, switching, and manipulation.

In this work, piezoelectrically-driven AlN-based in-plane actuator is introduced for the first time. The fabrication process of the actuator is easily compatible with mass production and the structure can be used as a platform for a wide range of devices from energy harvesters and compact gyroscopes to nanoswitches and manipulators.

Deposition of AlN thin films on planar surfaces is already quite well optimized and studied process for out-of-plane motion. But 3D piezoMEMS would require piezoelectric thin films on high aspect ratio structures of patterned substrates to achieve lateral motion. Metals and oxides grown on vertical surfaces have already been integrated into some MEMS devices and moreover can be used, for example, in through silicon vias. Meanwhile the deposition of piezoelectric films on vertical surfaces is much more challenging task and still not fully investigated for AlN. AlN thin films must meet certain criteria for piezoMEMS fabrication to gain the most effective movement in the in-plane direction.

Firstly, the films should be conformal all over the surface determined for the deposition i.e., have uniform thickness without gaps or pinholes. Unproportionally thin films increase chance of the dielectric breakdown and limit the maximum drive voltage. Secondly, AlN films must have good crystal quality and keep c-axis orientation perpendicular to the vertical surface of the device. c-axis oriented AlN with a large grain size and a narrow X-ray diffraction, XRD, rocking curve, XRC, around the (0002) reflection exhibit best piezoelectric properties. The importance of the right orientation of AlN films on the vertical surfaces for the efficient work of a device is determined by the non-centrosymmetric wurtzite structure of AlN along c-axis or parallel to [0001] direction. Thus, electric field should be aligned parallel to the c-axis of AlN for the maximum efficiency of the electromechanical coupling. The majority of the grains of the film have c-axis orientation perpendicular to vertical surface of Si. Thus, when the electric field is applied, the total deformation of the film is proportional to the applied voltage. The piezoelectric effect in AlN is averaged over all the grains, therefore reduction in crystal quality and orientation results in a reduction in electromechanical coupling and performance of the device, respectively.

It was previously confirmed that the tilt of AlN grains affects piezoelectric response in sputtered AlN films significantly. It is also worth adding that AlN cannot be poled in the same way as ferroelectric materials, thus orientation of AlN films can be controlled only by growth parameters.

Previous research has established that metalorganic chemical vapor deposited, MOCVD, AlN deposition on patterned Si (110) substrates demonstrates strong c-axis orientation perpendicular to Si (111) but lacking thickness uniformity. However, the thickness of the MOCVD AlN films on the vertical surfaces decreases a lot over the growth area and the films are usually thicker on the top part of the structure which is closer to the showerhead of the reactor. There are several reasons of poor conformality of the MOCVD AlN films grown on vertical surfaces: low temperature, high pressure, and insufficiently fast access of precursors to the bottom of the trench (when the deposition is for wafers with cavities). Also, MOCVD AlN films often have pinholes even when grown on planar surfaces. Moreover, for AlN, the temperature required for the growth is over 1000 °C, which is limiting materials that can be used in fabrication, for example as a bottom electrode. Additionally, high-temperature deposition results in large residual stresses in the films after the deposition. Furthermore, when using MOCVD, the crystal growth of the films depends on the substrate orientation a lot. This is mainly crucial for patterned substrates, where structures are formed by diverse etching methods and their surface is might not be ideally smooth. Consequently, a rough surface with a mismatching crystal lattice will result in the misorientation of AlN grains. Despite some of the limitations of this method, when the surface of the substrate is thoroughly prepared for the growth, MOCVD AlN films keep c-axis orientation and have higher crystal quality in general, when compared to other deposition methods.

High conformality is the main advantage of the atomic layer deposition, ALD, process compared to other CVD and PVD methods. Even though ALD is time-consuming and quite costly process, it has no analogs because of its repeatability, large area uniformity, low temperature deposition possibilities, and stress-free films. However, previously achieved ALD AlN films had quite weak piezoelectric response due to existing of randomly oriented grains in addition to the preferentially [0001] oriented grains. Also, a strong relationship between underlying layer and AlN orientation has been reported.

In this work, MOCVD was used as a method for AlN deposition because of its superior capability for the growth of high-quality textured c-axis oriented AlN on vertical surfaces.

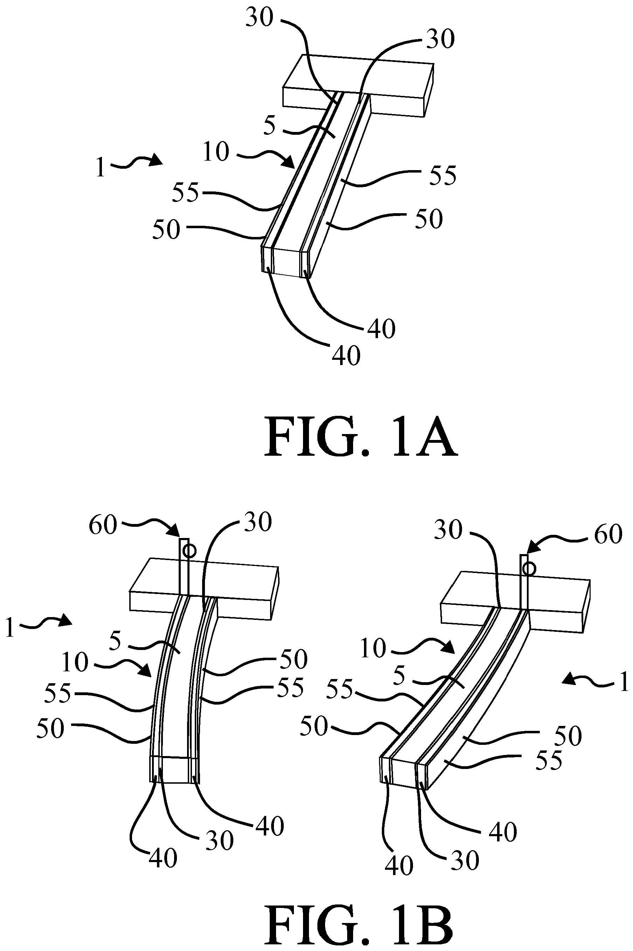

A schematic illustration of the working principle and a concept of the in-plane motion of the actuator are shown in Figures 1A and 1B. The device 1 can be a cantilever 10 structure with AlN thin film 40 sandwiched between the top, TE 50, and bottom, BE, 30 electrodes on the vertical walls of the Si cantilever 5, as shown in Figure 1A. When an electric field *E* is applied, the crystal lattice of AlN 40 deforms due to the charge separation along the c-axis, which empowers the in-plane motion of the cantilever as demonstrated in Figure 1B. In FIG. 1B, there is depicted a voltage source 60 connected to a top electrode 50 and to a bottom electrode 30.

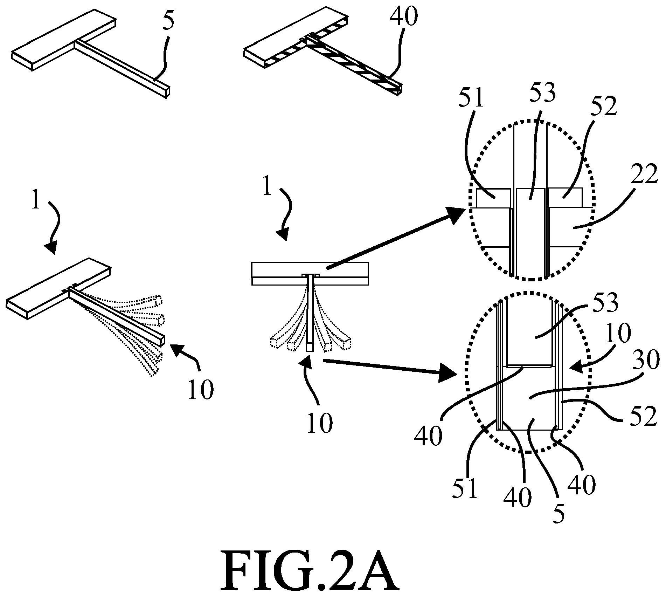

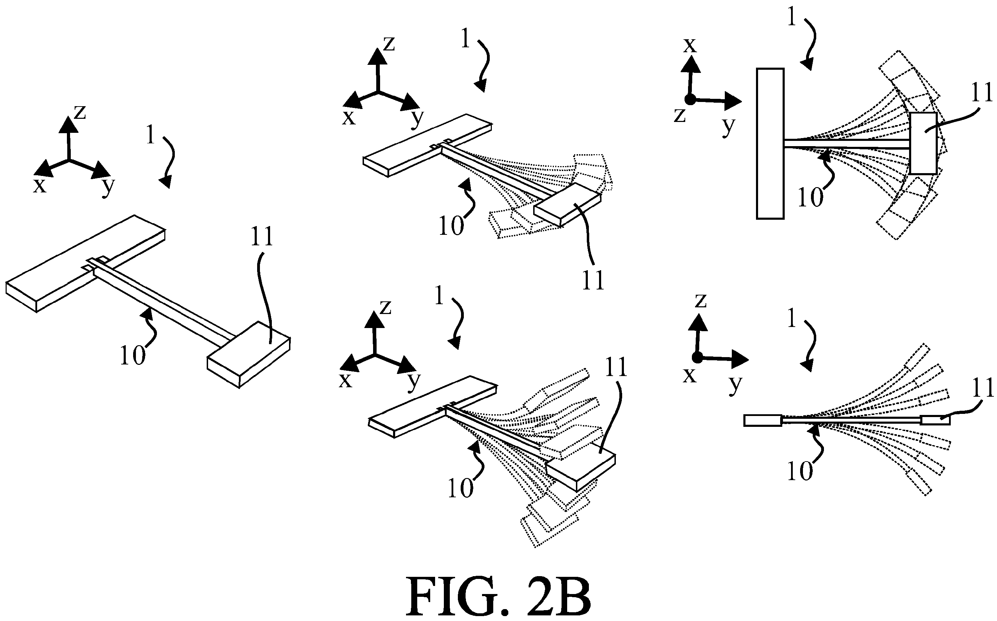

Figures 2A and 2B illustrate performance of the multiaxial MEMS device 1 performance. FIG. 2B illustrates the multiaxial MEMS device 1 performance as a multiaxial energy harvester illustrating in-plane (x-y plane) and out-of-plane (y-z plane) direction harvesting.

Deposition of piezoelectric AlN 40 on the lateral surfaces is required to acquire 3D motion. Additional TE/AlN films 55,40 might be placed on the top of lateral surface of the cantilever 5 in a similar way as shown in Figure 2A. Thus, AlN 40 on the top of the cantilever 5 enables out-of-plane motion when applying voltage on the top electrode (53 in Figure 2A) and in-plane motion is possible when applying voltage to the sidewall drive electrodes (51 and 52 in Figure 2A). The piezoelectric effect is inverse, so piezoactuator 1 can be transformed into energy harvester by adding proof mass 11 to the free end of the cantilever 10 as shown in Figure 2B. The harvested energy output can be maximized if the harvesters are placed in an array.

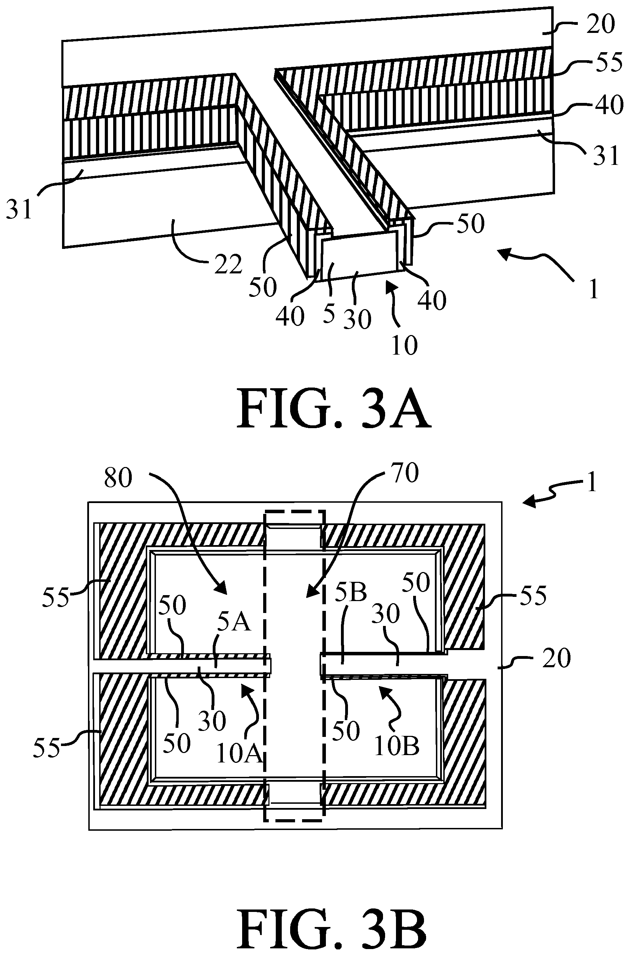

FIG. 3A and 3B illustrate the main parts of the device 1. In FIG 3A, the cantilever (10) comprises a Si(111) n++ device layer 20, TiN top electrodes 50, a buried oxide layer BOX SiO₂ 31, a handle wafer 20, and a MOVPE grown AlN 40 on sidewalls of a silicon cantilever 5. Two cantilevers 10A, 10B are shown separated by a silicon bridge area 70 and cavity 80 in FIG. 3B.

For the fabrication of piezoelectric actuators and harvesters, silicon-on-insulator, SOI, wafer can be used as a starting platform. Cantilevers 10 can be formed in a device layer of SOI, and a handle wafer can be etched through for the devices' 1 release at the end of the fabrication process. In this paper special terminology is used to describe different parts of the device during the fabrication. All parts of the piezoactuator 1 are shown in Figure 3. As was mentioned in the chapter AlN 40 growth on vertical surfaces, in this work MOCVD was used for the deposition of AlN films 40. MOCVD requires high temperatures for high-quality AlN growth. Hence, to avoid utilization of high-melting-point metals, SOI wafers with highly doped device layer were used. Highly doped Si operates as a substrate for the cantilever formation and BE simultaneously.

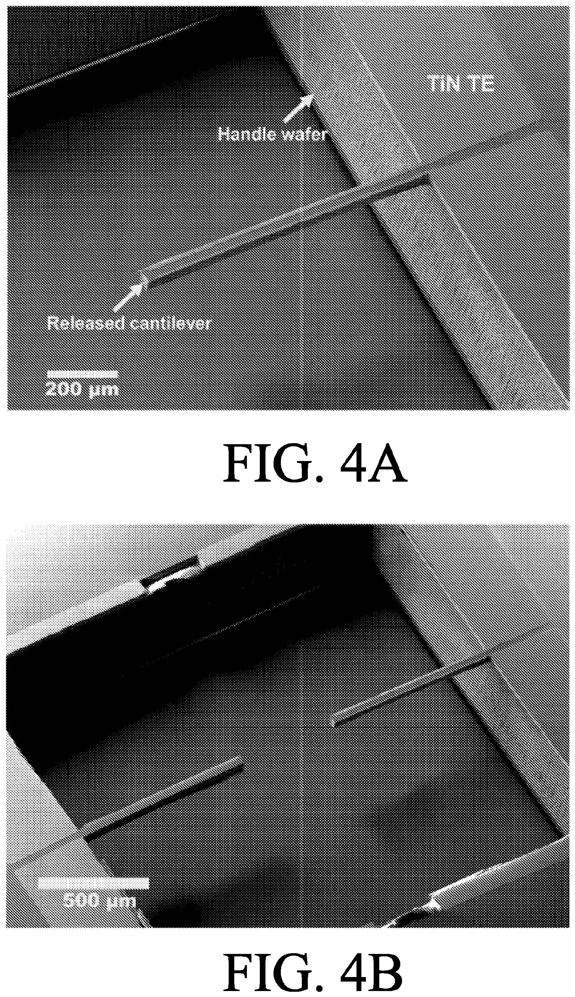

Cavities-first approach is a contemporary idea that was integrated into the fabrication flow of the piezoactuator. Such approach requires that cavities in the device layer of SOI are formed prior to thin film deposition, while conventional fabrication paths operate with thin films deposited on planar surfaces followed by cavity etching and element release. The area between cavities forms future cantilevers, as shown in Figure 3B. Si-bridge area 70 separates two cantilevers 10A, 10B and provides isolation between future TEs 50 on the left and right side of a cantilever 10A,10B. Figure 4 shows SEM micrographs of the released piezoactuators.

Table 1 presents the results obtained from high-resolution XRD scan on MOCVD AlN/Si(111) structures. As can be seen from the table, AlN films are high-quality crystalline with c-axis orientation. In the work by Österlund et al., was demonstrated that c-axis oriented growth of MOCVD AlN on blank Si (111) wafers indirectly indicates that AlN films keep c-axis orientation when grown on vertical surfaces with surface roughness 2.0±1.4 nm using the same growth parameters. Thus, same deposition parameters were used for AlN growth on the vertical surfaces of the piezoelectric cantilever.

| Table 1. High resolution XRD results of AlN films grown on the blank Si(111) substrates. | | | | | | |
|---|---|---|---|---|---|---|
| | | 2θ- ω | | | 0002 XRC | |
| Growth time, s | Thickness, nm | 2θ (°) | FWHM, (°) | d, Å | Ω (°) | FWHM, (°) |
| 1860 | 300 | 36.1 | 0.11 | 2.48 | 18.02 | 1.320 |
| 3600 | 500 | 36.1 | 0.06 | 2.48 | 18.17 | 0.470 |
| 7000 | 1000 | 35.8 | 0.22 | 2.50 | 17.92 | 0.445 |

The measured profiles of the AlN film on vertical sidewalls showed that the thickness of the film decreases from 750 to 166 nm from the top to bottom of the cantilever's wall after 7000 s of growth. AlN films thickness profile remains same for both types of samples: when the deposition is on patterns etched in ICP-RIE or KOH. EBSD results demonstrate that the AlN film retains its crystal quality and c-axis texture on vertical sidewalls only for samples with KOH-etched cavities, while AlN grown on samples with dry-etched cavities has poor crystal quality.

Table 2 summarizes simulated values of eigenfrequency *fᵣ* for the piezoelectric actuators obtained for varying length and width of the device. Thus, the required operational frequencies are in the range from 0.024 (0.028) to 1.694 (1.800) MHz.

FEA simulated results of displacement in-plane direction for cantilevers with varying length and width were obtained when the drive voltage was equal to 10 V. Results show that the maximum amplitude of the deflection along the length of the piezoactuator changes significantly with the change of AlN and TE's thickness. The maximum displacement for the piezoactuators, that have 300 nm TiN electrode and 1000 nm thick AlN piezolayer, is 1.5 times higher than for the actuators of the same geometry with thinner TiN/AlN films. Reduction of the actuator's deflection value happens because of the increase in overall thickness of the structure when deposited thicker AlN and TEs so the cantilever became stiffer and thus more resistant to deformation. Same behavior of the actuator is demonstrated when increasing the width of the cantilever only. The in-plane deflection increases exponentially when increasing cantilever's length. In addition, out-of-plane displacement is negligible to the in-plane displacement, especially for long cantilevers thus it was not represented on the graphs. Thereby, presented actuator is supposed to perform only lateral motion.

| Table 2. Simulated values of resonance frequency for the actuators with varying length and width. | | | |
|---|---|---|---|
| | | Resonance frequency *fᵣ*, MHz | |
| Length, µm | Width, µm | AlN=300 nm, TE = 100nm | AlN=1000 nm, TE = 300 nm |
| 200 - 1100 | 20 | 0.732 - 0.024 | 0.833 - 0.028 |
| | 30 | 1.063 - 0.035 | 1.169 - 0.039 |
| | 40 | 1.385 - 0.047 | 1.491 - 0.051 |
| | 50 | 1.694 - 0.058 | 1.800- 0.062 |

This work has demonstrated the fabrication flow for the first AlN-driven in-plane actuator. This work examined the impact of the cantilever's geometry on the maximum displacement amplitude and resonance frequency of the actuator using finite element method simulations. The main goal of this work was to demonstrate the completed design of the device that performs lateral motion of the released cantilever utilizing as a drive force piezoelectric properties of AlN thin films deposited on the vertical surfaces. The design of the presented device might be adapted for the fabrication of more complex 3D piezoMEMS.

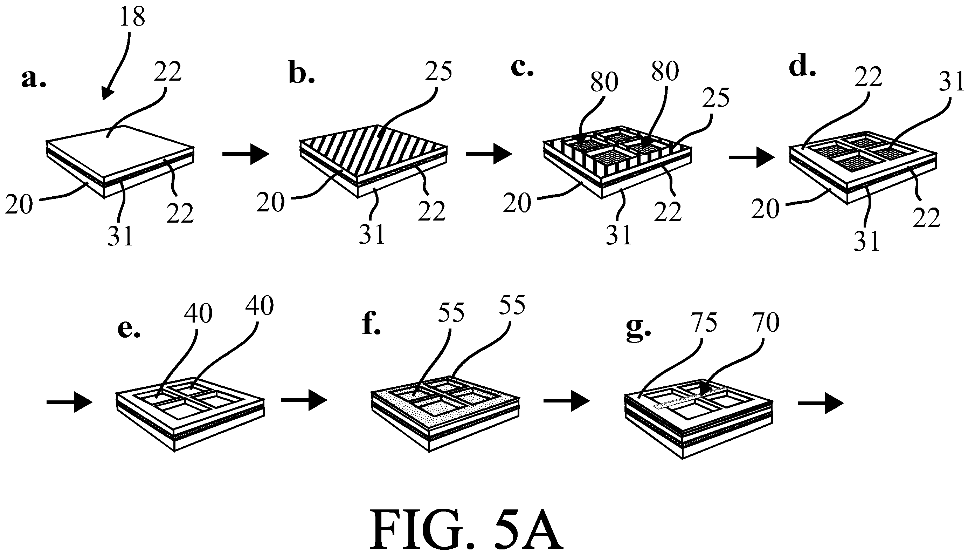

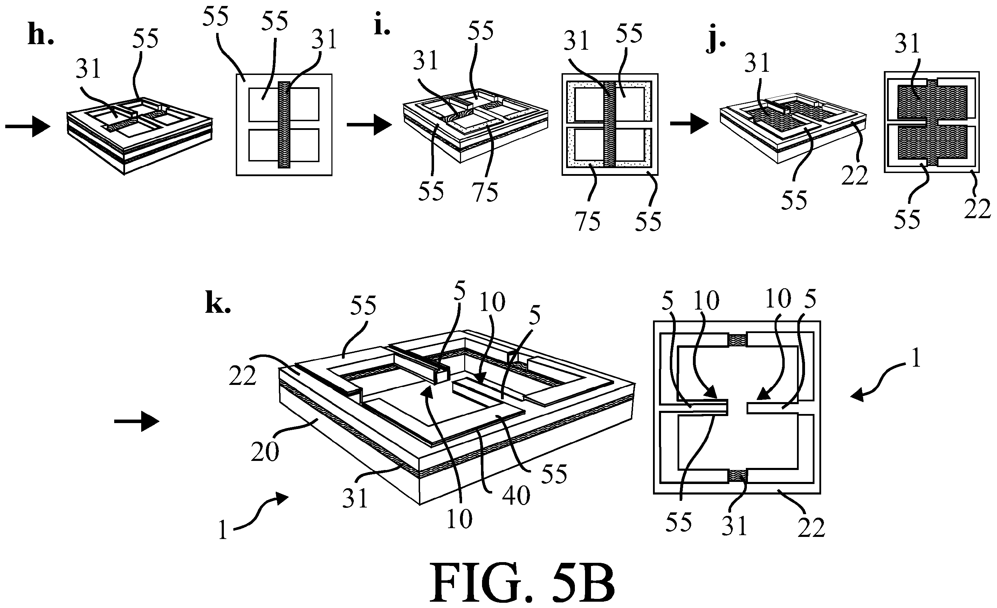

FIG. 5A and FIG. 5B. Illustration of the fabrication line of the device and picture of the device area.

The fabrication of the piezoactuator is described. Thick 1 µm wet thermal oxide SiO₂ layer was formed on the device layer 22 and the handle wafer 20 of SOI wafers 18. Cavities formation in the device layer 22 was implemented using two different approaches: dry and wet etching. Dry etching was conducted using cryo-etching in inductively coupled plasma RIE, ICP-RIE, Plasmalab 100. Etching was done in sulfur hexafluoride SF₆ (40 sccm, standard cubic meters per minute) and oxygen O₂ (6 sccm) plasma at -110°C. Wet etching was implemented in potassium hydroxide (KOH) 40wt% aqueous solution at 70°C for 66 min.

After that, textured AlN films 40 were deposited on patterned substrates using Aixtron 1x4" close-coupled showerhead MOVPE. Firstly, the wafer 20 is being annealed for 5 min in hydrogen (H₂) and 10 more minutes in disilane, Si₂H₆, at 1025 °C and 300 mbar reactor pressure. Nitridation was done under ammonia, NH3, atmosphere for 15 s at 100 mbar and substrate temperature 980 °C. NH₃ gas flow was 15 sccm. Trimethylaluminium, TMAl and NH3 were used as precursors for aluminum and nitrogen, respectively. AlN 40 was grown at 1085 °C substrate temperature in pressure of 100 mbar with H₂ carrier gas. V/III ratio was kept 336.05 during both low-temperature, LT and high-temperature, HT AlN 40 growth. Substrate temperature setpoint for LT and HT AlN was 980 °C and 1085 °C, respectively.

On the top of MOCVD AlN 40, TiN 55 was deposited in ALD reactor Picosun SUNALE R-200 Advanced. The deposition is implemented in thermal mode of the reactor. As precursors titanium tetrachloride, TiCl₄, and TMAl were used. TiCl₄ was used for 0.1 s pulse and 6 s purge under 80 sccm flow. TMAl was used for 0.1 s pulse and 3.6 s purge under 60 sccm flow. Deposition was implemented at 450 °C.

Further, the structure was patterned as shown in Figure 5A and 5B steps g-h using thick layer of SU-8 75 for the etching of the Si-bridge area 70. Firstly, AlN/TiN layers 40,55 were etched using gas chlorine (18 sccm) and argon (6 sccm) in ICP-RIE. Then, underlaying Si was etched away using BOSCH-process in STS Deep RIE Etcher. Etching step was done in SF₆ (130 sccm) and O₂ (13 sccm) with coil power P_{coil}=600 W and bias power P_{bias}=12 W. Octafluorocyclobutane (C4F8) was used for a passivation step. C₄F₈ gas flow was 85 sccm at P_{coil}=600W and P_{bias}=0 W. Hereafter, the wafer was patterned for TE formation, as shown in Figure 5B steps i-j. For TEs formation, AlN 40 and TiN 55 were etched using same procedure as described for Si-bridge etching. Cantilevers 10 were released via through handle wafer 20 DRIE in SF₆/O₂ using same etching conditions as for Si-bridge etching.

The crystal quality of AlN thin films on blank Si (111) wafers was measured using XRD Rigaku SmartLab. Symmetrical 2θ-ω and XRC were measured around the 0002 reflection. The thickness of the films was measured using a spectroscopic ellipsometer. For orientation assessment of the films on the sidewalls electron backscatter diffraction EBSD method was used.

To investigate the effect of the actuator's geometry on the resonance frequency and deflection value of the device, finite-element-modeling FEM was used in "Solid mechanics" and "Electrostatics" interfaces of COMSOL Multiphysics. Design parameters were taken from Table 3.

| Table 3. Design parameters. | | |
|---|---|---|
| Parameter name | Values | Description |
| AlN thickness | 300 nm, 1µm | Thickness of the piezoelectric film on the vertical surfaces of the actuator |
| TE (TiN) thickness | 100 nm, 300 nm | Thickness of the top electrodes |
| L | 200 ... 1000 µm | Length of the actuator. Step: 100 µm |
| w | 20, 30, 40, 50 µm | Width of the actuator |
| h | 50 µm | Height of the actuator, thickness of the device layer |

Motion tests of the fabricated actuators were implemented using Imina Technologies nanoprobing station for in-situ electrical measurements. Displacement measurements were conducted in Zeiss Supra 40 SEM chamber at the vacuum level.

According to the present disclosure, there is provided a method for manufacturing a MEMS transducer, the method comprising forming at least one cantilever from a silicon-on-insulator SOI wafer, wherein the at least one cantilever comprises a first sidewall, a second sidewall substantially parallel to the first sidewall, an aluminium nitride AlN layer and a top electrode, and wherein said top electrode is connected to at least the first sidewall and/or the second sidewall via the AlN layer therebetween.

In an exemplary process, not showing all features of the invention as claimed, there is provided a method for manufacturing a microelectromechanical system (MEMS) device, the method comprising steps a-k, such that:
- in step a, SOI wafer 18 comprising a highly doped silicon (Si n++) device layer 22, BOX SiO₂ 31 and silicon handle wafer 20 is obtained;
- in step b, thermal oxide layer, SiO₂, 25 having a thickness 1 µm, is grown on top of the highly doped silicon device layer 22;
- in step c, cavities 80 are formed in the device layer 22 using the thermal SiO₂ 25 as a hard mask;
- in step d, SiO₂ is etched in buffered oxide etch BHF;
- in step e, aluminium nitride, AlN, 40 is grown using metalorganic vapor phase epitaxy MOVPE;
- in step f, titanium nitride, TiN, 55 is deposited using atomic layer deposition;
- in step g, an SU-8 photoresist 75 is deposited and patterned on to the grown and/or deposited layers such that silicon bridge area is patterned;
- in step h, a silicon bridge area 70 is etched such that part of the BOX SiO₂ layer 31 is exposed;
- in step i, TiN and AlN layers 55,40 are patterned using an SU-8 photoresist 75;
- in step j, TiN and AlN layers 55,40 are etched using inductively coupled plasma reactive-ion etching ICP-RIE; and
- in step k, handle wafer 20 is etched using deep reactive-ion etching DRIE, and part of the buried oxide layer 31 and the handle wafer 20 are removed such that cantilever 10 is released thereby forming a MEMS transducer 1.

### INDUSTRIAL APPLICABILITY

At least some embodiments of the present disclosure find industrial application at least in the manufacture and use of microelectromechanical systems (MEMS), nanoelectromechanical systems (NEMS) and specifically electrostatic and piezoelectric NEMS/MEMS transduction and NEMS/MEMS actuation.

### ACRONYMS LIST

- ALD: atomic layer deposition
- AR: augmented reality
- BE: bottom electrode
- BHF: buffered oxide etch, buffered hydrofluoric etch
- CVD: chemical vapor deposition
- DC: direct current
- DRIE: deep reactive-ion etching
- *E*: electric field
- EBSD: electron backscatter diffraction
- FEA: finite element analysis
- FEM: finite element modelling
- *fᵣ*: eigenfrequency
- HT: high-temperature
- ICP-RIE: inductively coupled plasma reactive ion etching
- ICP: inductively coupled plasma
- LT: low-temperature
- MEMS: microelectromechanical systems
- MOCVD: metalorganic chemical vapor deposition
- MOVPE: metalorganic vapour-phase epitaxy
- NEMS: nanoelectromechanical systems
- piezoMEMS: piezoelectric-based MEMS
- PVD: physical vapor deposition
- SF6: sulfur hexafluoride
- SEM: scanning electron microscopy
- SOI: silicon-on-insulator
- SU-8: an epoxy-based negative photoresist
- TE: top electrode
- TMAl: trimethylaluminium
- VR: virtual reality
- XRD: X-ray diffraction
- XRC: X-ray diffraction rocking curve

### REFERENCE SIGNS LIST

- 1: MEMS transducer
- 5, 5A, 5B: silicon cantilever
- 10,10A,10B: cantilever
- 11: proof mass
- 18: silicon on insulator SOI wafer
- 20: handle wafer
- 22: device layer
- 25: SiO₂ thermal oxide
- 30: bottom electrode, BE
- 31: buried oxide layer SiO2 layer
- 40: aluminium nitride layer AlN
- 50: top electrode
- 51: first top electrode
- 52: second top electrode
- 53: third top electrode
- 55: titanium nitride layer TiN
- 60: voltage source
- 70: silicon-bridge area
- 75: SU-8 photoresist
- 80: cavity

### CITATION LIST

### Patent Literature

CN113 364 423 A

### Non Patent Literature

A. Gabrelian, G. Ross, K. Bespalova, M. Paulasto-Krockel, Materials Today Communications 2022, 33, p.104522.
E. Österlund, S. Suihkonen, G. Ross, A. Torkkeli, H. Kuisma, M. Paulasto-Krockel, Journal of Crystal Growth 2020, 531, p.125345.
Ü. Sökmen et al. "Evaluation of resonating Si cantilevers sputter deposited with AlN piezoelectric thin films for mass sensing applications" Journal of Micromechanics and Microengineering, Institute of Physics Publishing, Bristol, GB, vol. 20, no. 6, 1 June 2010 (2010-06-01), page 64007, XP020192935, ISSN: 0960-1317, DOI: 10.1088/0960-1317/6/064007
S. Guido et al. "Study on the effectiveness of different electrode geometries for sputtered Aluminium Nitride-based MEMS energy harvesters", 2016 Symposium on design, test, integration and packaging of MEMS/MOEMS (DTIP), IEEE, 30 May 2016 (2016-05-30), pages 1-4, XP032925571, DOI: 10.1109/DTIP.2016.75714871

## Claims

1. A method for manufacturing a piezoelectric MEMS transducer (1), the method comprising forming at least one cantilever (10) from a silicon-on-insulator SOI wafer (18) by
- obtaining the silicon-on-insulator SOI wafer (18) comprising highly doped silicon device layer (22), a buried oxide layer (31) and a handle wafer (20);
- etching in part the highly doped silicon device layer (22) and thereby forming at least one cavity (80) in the highly doped device layer (22), said at least one cavity (80) exposing part of the buried oxide layer (31), and wherein said at least one cavity (80) is at least in part delimited by the exposed part of the buried oxide layer (31) and the first sidewall and the second sidewall of the highly doped silicon device layer (22), and wherein the at least one cavity (80) is further delimited by a silicon-bridge area (70);
- depositing an aluminium nitride AlN layer (40) at least on the highly doped silicon device layer (22), the first sidewall, the second sidewall and the exposed part of the buried oxide layer (31);
- depositing a titanium nitride TiN layer (55) at least on the AlN layer (40);
- prior to forming a top electrode, etching the silicon bridge area (70), thereby exposing part of the buried oxide layer (31);
- forming the top electrode (50) from the TiN layer (55); and
- releasing the at least one cantilever (10);
wherein the at least one cantilever (10) comprises the first sidewall, the second sidewall substantially parallel to the first sidewall, the aluminium nitride AlN layer (40) and the top electrode (50), and
wherein said top electrode (50) is connected to at least the first sidewall and/or the second sidewall via the AlN layer (40) therebetween.

2. The method according to claim 1, wherein etching the at least one cavity (80) comprises dry etching by cryo-etching the highly doped silicon device layer (22) using inductively coupled plasma reactive-ion etching ICP-RIE in sulfur hexafluoride SF6 and oxygen O₂.

3. The method according to claim 1, wherein etching the at least one cavity (80) comprises wet etching the highly doped silicon device layer (22) with potassium hydroxide KOH aqueous solution.

4. The method according to any one of the preceding claims, wherein the surface roughness of the sidewalls after etching the at least one cavity (80) is 0.6 nm to 3.4 nm.

5. The method according to any one of the preceding claims, wherein depositing the aluminium nitride AlN layer (40) comprises using metalorganic vapour-phase epitaxy MOVPE, the deposition of the AlN layer (40) comprising:
- annealing the SOI wafer (18) in hydrogen H₂;
- annealing the SOI wafer (18) in disilane SiH₆;
- nitriding the SOI wafer (18) under ammonia NH₃ atmosphere;
- low temperature growing AlN layer (40) on the SOI wafer (18) in a H₂ carrier gas;
and
- high temperature growing AlN layer (40) on the SOI wafer (18) in a H₂ carrier gas.

6. The method according to any one of the preceding claims, wherein the AlN layer (40) comprises a substantially c-axis crystal orientation.

7. The method according to any one of the preceding claims, wherein depositing the titanium nitride TiN layer (55) comprises thermal atomic layer deposition of titanium nitride TiN on top of the AlN layer (40).

8. The method according to any one of the preceding claims, wherein etching the silicon-bridge area (70), comprises:
- etching the AlN layer (40) and TiN layer (55) on the silicon-bridge area (70) using induction coupled plasma reactive-ion etching, ICP-RIE, using chlorine gas and argon and exposing underlaying part of the highly doped silicon device layer (22); and
- etching the exposed underlaying part of the highly doped silicon device layer (22), wherein the etching is reactive-ion etching in SF6 and O₂.

9. The method according to any one of the preceding claims, wherein forming the top electrode (50), by etching the aluminium nitride AlN layer (40) and the titanium nitride TiN layer (55), comprises:
- etching the AlN layer (40) and TiN (55) layer using in inductively coupled plasma reactive-ion etching, ICP-RIE, using chlorine gas and argon and exposing underlaying part of highly doped silicon device layer (22); and
- reactive-ion etching the exposed underlaying part of highly doped silicon device layer (22) in SF6 and O₂.

10. The method according to any one of the preceding claims, wherein releasing the at least one cantilever (10) comprises:
- deep reactive-ion etching, DRIE, the buried oxide layer (31) and handle wafer (20) in SF₆ and O₂.

11. The method according to any one of the preceding claims, wherein the highly doped silicon device layer (22) has a surface with substantially Si(111) crystalline orientation.

12. The method according to according to any one of the preceding claims, wherein forming the top electrode (50) comprises
- forming a first electrode (51) on the first sidewall;
- forming a second electrode (52) on the second sidewall substantially parallel to the first sidewall; and
- forming a third electrode (53) on a top portion of the cantilever, wherein said top portion is connected and perpendicular to the first sidewall and the second sidewall.

13. The method according to any one of the preceding claims, wherein prior to etching the at least one cavity (80), the method comprises forming a wet thermal oxide SiO₂ layer (25) on the highly doped silicon device layer (22).

14. The method according to claim 13, wherein prior to depositing the aluminium nitride AlN layer (40), the wet thermal oxide SiO₂ layer (25) is removed using buried oxide etch, BHF.

15. The method according to any one of the preceding claims, wherein the etching the silicon bridge area (70) comprises:
- etching the silicon bridge area such that two cantilevers (10A, 10B) comprising the at least one cantilever (10) are formed upon releasing the at least one cantilever (10),
wherein said two cantilevers (10A, 10B) are separated by said silicon bridge area (70).

## Patentansprüche

1. Verfahren zur Herstellung eines piezoelektrischen MEMS-Wandlers (1), wobei das Verfahren Bilden zumindest eines Auslegers (10) aus einem Silizium-auf-Isolator-, SOI-Wafer (18) umfasst, durch
- Herstellen des Silizium-auf-Isolator-, SOI-Wafers (18), umfassend eine hochdotierte Silizium-Vorrichtungsschicht (22), eine vergrabene Oxidschicht (31) und einem Handhabungswafer (20);
- teilweises Ätzen der hochdotierten Silizium-Vorrichtungsschicht (22) und dadurch Bilden zumindest eines Hohlraums (80) in der hochdotierten Vorrichtungsschicht (22), wobei der zumindest eine Hohlraum (80) einen Teil der vergrabenen Oxidschicht (31) freilegt, und wobei der zumindest eine Hohlraum (80) zumindest teilweise durch den freigelegten Teil der vergrabenen Oxidschicht (31) und die erste Seitenwand und die zweite Seitenwand der hochdotierten Silizium-Vorrichtungsschicht (22) begrenzt ist, und wobei der zumindest eine Hohlraum (80) weiter durch einen Silizium-Brückenbereich (70) begrenzt ist;
- Abscheiden einer Aluminiumnitrid-, AlN-Schicht (40) zumindest auf der hochdotierten Silizium-Vorrichtungsschicht (22), der ersten Seitenwand, der zweiten Seitenwand und dem freigelegten Teil der vergrabenen Oxidschicht (31);
- Abscheiden einer Titannitrid-, TiN-Schicht (55) zumindest auf der AlN-Schicht (40);
- vor Bilden einer oberen Elektrode, Ätzen des Silizium-Brückenbereichs (70), wodurch ein Teil der vergrabenen Oxidschicht (31) freigelegt wird;
- Bilden der oberen Elektrode (50) aus der TiN-Schicht (55); und
- Freigeben des zumindest einen Auslegers (10);
wobei der zumindest eine Ausleger (10) die erste Seitenwand, die im Wesentlichen parallel zu der ersten Seitenwand verlaufende zweite Seitenwand, die Aluminiumnitrid-, AlN-Schicht (40) und die obere Elektrode (50) umfasst, und
wobei die obere Elektrode (50) mit zumindest der ersten Seitenwand und/oder der zweiten Seitenwand über die AlN-Schicht (40) dazwischen verbunden ist.

2. Verfahren nach Anspruch 1, wobei Ätzen des zumindest einen Hohlraums (80) Trockenätzen durch Kryoätzen der hochdotierten Silizium-Vorrichtungsschicht (22) unter Verwendung induktiv gekoppelten reaktiven Plasma-Ionenätzens, ICP-RIE in Schwefelhexafluorid SF6 und Sauerstoff O₂ umfasst.

3. Verfahren nach Anspruch 1, wobei Ätzen des zumindest einen Hohlraums (80) Nassätzen der hochdotierten Silizium-Vorrichtungsschicht (22) mit wässriger Kaliumhydroxid-, KOH-Lösung umfasst.

4. Verfahren nach einem der vorstehenden Ansprüche, wobei die Oberflächenrauheit der Seitenwände nach Ätzen des zumindest einen Hohlraums (80) 0,6 nm bis 3,4 nm beträgt.

5. Verfahren nach einem der vorstehenden Ansprüche, wobei Abscheiden der Aluminiumnitrid-n AlN-Schicht (40) Verwenden metallorganischer Gasphasenepitaxie, MOVPE umfasst, wobei das Abscheiden der AlN-Schicht (40) umfasst:
- Tempern des SOI-Wafers (18) in Wasserstoff H₂;
- Tempern des SOI-Wafers (18) in Disilan SiH₆;
- Nitrieren des SOI-Wafers (18) unter Ammoniak-, NH₃-Atmosphäre;
- Niedertemperaturzüchten einer AlN-Schicht (40) auf dem SOI-Wafer (18) in einem H₂-Trägergas; und
- Hochtemperaturzüchten einer AlN-Schicht (40) auf dem SOI-Wafer (18) in einem H₂-Trägergas.

6. Verfahren nach einem der vorstehenden Ansprüche, wobei die AlN-Schicht (40) im Wesentlichen eine c-Achsen-Kristallorientierung umfasst.

7. Verfahren nach einem der vorstehenden Ansprüche, wobei Abscheiden der Titannitrid-, TiN-Schicht (55) thermische Atomlagenabscheidung von Titannitrid TiN über der AlN-Schicht (40) umfasst.

8. Verfahren nach einem der vorstehenden Ansprüche, wobei Ätzen des Silizium-Brückenbereichs (70) umfasst:
- Ätzen der AlN-Schicht (40) und der TiN-Schicht (55) auf dem Silizium-Brückenbereich (70) unter Verwendung von induktionsgekoppeltem reaktivem Plasma-Ionenätzen, ICP-RIE, unter Verwendung von Chlorgas und Argon und Freilegen des darunterliegenden Teils der hochdotierten Silizium-Vorrichtungsschicht (22); und
- Ätzen des freigelegten darunterliegenden Teils der hochdotierten Silizium-Vorrichtungsschicht (22), wobei es sich beim Ätzen um reaktives Ionenätzen in SF6 und O₂ handelt.

9. Verfahren nach einem der vorstehenden Ansprüche, wobei Bilden der oberen Elektrode (50) durch Ätzen der Aluminiumnitrid-, AlN-Schicht (40) und der Titannitrid-, TiN-Schicht (55) umfasst:
- Ätzen der AlN-Schicht (40) und TiN-Schicht (55) unter Verwendung von induktiv gekoppelten reaktivem Plasma-Ionenätzen, ICP-RIE, unter Verwendung von Chlorgas und Argon und Freilegen des darunterliegenden Teils der hochdotierten Silizium-Vorrichtungsschicht (22); und
- reaktives Ionenätzen des freigelegten darunterliegenden Teils der hochdotierten Silizium-Vorrichtungsschicht (22) in SF6 und O₂.

10. Verfahren nach einem der vorstehenden Ansprüche, wobei Freigeben des zumindest einen Auslegers (10) umfasst:
- Reaktives Ionentiefenätzen, DRIE, der vergrabenen Oxidschicht (31) und des Handhabungswafers (20) in SF₆ und O₂.

11. Verfahren nach einem der vorstehenden Ansprüche, wobei die hochdotierte Silizium-Vorrichtungsschicht (22) eine Oberfläche mit im Wesentlichen Si(111)-Kristallorientierung aufweist.

12. Verfahren nach einem nach einem der vorstehenden Ansprüche, wobei Bilden der oberen Elektrode (50) umfasst
- Bilden einer ersten Elektrode (51) an der ersten Seitenwand;
- Bilden einer zweiten Elektrode (52) an der zweiten Seitenwand im Wesentlichen parallel zu der ersten Seitenwand; und
- Bilden einer dritten Elektrode (53) auf einem oberen Abschnitt des Auslegers, wobei der obere Abschnitt mit der ersten Seitenwand und der zweiten Seitenwand verbunden ist und senkrecht zu diesen steht.

13. Verfahren nach einem der vorstehenden Ansprüche, wobei das Verfahren vor dem Ätzen des zumindest einen Hohlraums (80) Bilden einer nassen thermischen SiO₂-Oxidschicht (25) auf der hochdotierten Silizium-Vorrichtungsschicht (22) umfasst.

14. Verfahren nach Anspruch 13, wobei vor Abscheiden der Aluminiumnitrid-, AlN-Schicht (40) die nasse thermische SiO₂-Oxidschicht (25) unter Verwendung von vergrabenem Oxidätzen, BHF, entfernt wird.

15. Verfahren nach einem der vorstehenden Ansprüche, wobei das Ätzen des Silizium-Brückenbereichs (70) umfasst:
- Ätzen des Silizium-Brückenbereichs, sodass zwei Ausleger (10A, 10B), welche den zumindest einen Ausleger (10) umfassen, beim Freigeben des zumindest einen Auslegers (10) gebildet werden, wobei die zwei Ausleger (10A, 10B) durch den Silizium-Brückenbereich (70) getrennt sind.

## Revendications

1. Procédé de fabrication d'un transducteur MEMS piézoélectrique (1), le procédé comprenant la formation d'au moins un porte-à-faux (10) à partir d'une plaquette de silicium sur isolant, SOI, (18) en
- obtenant la plaquette de silicium sur isolant, SOI, (18) comprenant une couche de dispositif en silicium fortement dopée (22), une couche d'oxyde enfouie (31) et une plaquette de poignée (20);
- gravant, en partie, la couche de dispositif en silicium fortement dopée (22) et, de ce fait, formant au moins une cavité (80) dans la couche de dispositif fortement dopée (22), ladite au moins une cavité (80) exposant une partie de la couche d'oxyde enfouie (31), et dans lequel ladite au moins une cavité (80) est, au moins en partie, délimitée par la partie exposée de la couche d'oxyde enfouie (31) et la première paroi latérale et la seconde paroi latérale de la couche de dispositif en silicium fortement dopée (22), et dans lequel la au moins une cavité (80) est en outre délimitée par une zone de pont en silicium (70) ;
- déposant une couche de nitrure d'aluminium, AIN, (40) au moins sur la couche de dispositif en silicium fortement dopée (22), la première paroi latérale, la seconde paroi latérale et la partie exposée de la couche d'oxyde enfouie (31) ;
- déposant une couche de nitrure de titane, TiN, (55) au moins sur la couche d'AIN (40);
- avant de former une électrode supérieure, gravant la zone de pont en silicium (70), exposant, de ce fait, une partie de la couche d'oxyde enfouie (31) ;
- formant l'électrode supérieure (50) à partir de la couche de TiN (55) ; et
- libérant le au moins un porte-à-faux (10) ;
dans lequel le au moins un porte-à-faux (10) comprend la première paroi latérale, la seconde paroi latérale sensiblement parallèle à la première paroi latérale, la couche de nitrure d'aluminium, AIN, (40) et l'électrode supérieure (50), et
dans lequel ladite électrode supérieure (50) est reliée à au moins la première paroi latérale et/ou la seconde paroi latérale via la couche d'AIN (40) entre elles.

2. Procédé selon la revendication 1, dans lequel la gravure de la au moins une cavité (80) comprend une gravure sèche par cryo-gravure de la couche de dispositif en silicium hautement dopée (22) à l'aide d'une gravure ionique réactive par plasma à couplage inductif (ICP-RIE) dans l'hexafluorure de soufre SF6 et l'oxygène O₂.

3. Procédé selon la revendication 1, dans lequel la gravure de la au moins une cavité (80) comprend la gravure humide de la couche de dispositif en silicium fortement dopée (22) avec une solution aqueuse d'hydroxyde de potassium KOH.

4. Procédé selon l'une quelconque des revendications précédentes, dans lequel la rugosité de surface des parois latérales après gravure de la au moins une cavité (80) est 0,6 nm à 3,4 nm.

5. Procédé selon l'une quelconque des revendications précédentes, dans lequel le dépôt de la couche de nitrure d'aluminium, AIN, (40) comprend l'utilisation de l'épitaxie en phase vapeur organométallique, MOVPE, le dépôt de la couche d'AIN (40) comprenant :
- le recuit de la plaquette de SOI (18) sous hydrogène H₂;
- le recuit de la plaquette de SOI (18) dans le disilane SiH₆;
- la nitruration de la plaquette de SOI (18) sous atmosphère d'ammoniac NH₃ ;
- la croissance à basse température d'une couche d'AIN (40) sur la plaquette de SOI (18) dans un gaz vecteur H₂ ; et
- la croissance à haute température d'une couche d'AIN (40) sur la plaquette de SOI (18) dans un gaz vecteur H₂.

6. Procédé selon l'une quelconque des revendications précédentes, dans lequel la couche d'AIN (40) comprend une orientation cristalline sensiblement selon l'axe c.

7. Procédé selon l'une quelconque des revendications précédentes, dans lequel le dépôt de la couche de nitrure de titane, TiN, (55) comprend un dépôt de couche atomique thermique de nitrure de titane, TiN, sur la couche d'AIN (40).

8. Procédé selon l'une quelconque des revendications précédentes, dans lequel la gravure de la zone de pont en silicium (70) comprend :
- la gravure de la couche d'AIN (40) et de la couche de TiN (55) sur la zone de pont en silicium (70) à l'aide d'une gravure ionique réactive par plasma à couplage inductif (ICP-RIE), à l'aide du chlore gazeux et de l'argon et l'exposition de la partie sous-jacente de la couche de dispositif en silicium fortement dopée (22) ; et
- la gravure de la partie sous-jacente exposée de la couche de dispositif en silicium fortement dopée (22), dans lequel la gravure est une gravure ionique réactive dans SF6 et O₂

9. Procédé selon l'une quelconque des revendications précédentes, dans lequel la formation de l'électrode supérieure (50), en gravant la couche de nitrure d'aluminium, AIN, (40) et de la couche de nitrure de titane, TiN, (55), comprend :
- la gravure de la couche d'AIN (40) et de la couche de TiN (55) par gravure ionique réactive au plasma à couplage inductif (ICP-RIE), à l'aide du chlore gazeux et de l'argon, et l'exposition de la partie sous-jacente de la couche de dispositif en silicium fortement dopée (22) ; et
- la gravure ionique réactive de la partie sous-jacente exposée de la couche de dispositif en silicium fortement dopée (22) dans SF6 et O₂.

10. Procédé selon l'une quelconque des revendications précédentes, dans lequel la libération du au moins un porte-à-faux (10) comprend :
- la gravure ionique réactive profonde, DRIE, de la couche d'oxyde enfouie (31) et de la plaquette de manipulation (20) dans SF6 et O₂.

11. Procédé selon l'une quelconque des revendications précédentes, dans lequel la couche de dispositif en silicium fortement dopée (22) présente une surface avec une orientation cristalline sensiblement Si(111).

12. Procédé selon l'une quelconque des revendications précédentes, dans lequel la formation de l'électrode supérieure (50) comprend
- la formation d'une première électrode (51) sur la première paroi latérale ;
- la formation d'une deuxième électrode (52) sur la seconde paroi latérale sensiblement parallèle à la première paroi latérale ; et
- la formation d'une troisième électrode (53) sur une partie supérieure du porte-à-faux, dans lequel ladite partie supérieure est reliée, et perpendiculaire, à la première paroi latérale et à la seconde paroi latérale.

13. Procédé selon l'une quelconque des revendications précédentes, dans lequel, avant de graver la au moins une cavité (80), le procédé comprend la formation d'une couche d'oxyde thermique humide SiO₂ (25) sur la couche de dispositif en silicium fortement dopée (22).

14. Procédé selon la revendication 13, dans lequel, avant de déposer la couche de nitrure d'aluminium, AIN, (40), la couche d'oxyde thermique humide SiO₂ (25) est éliminée à l'aide d'une gravure d'oxyde enfouie, BHF.

15. Procédé selon l'une quelconque des revendications précédentes, dans lequel la gravure de la zone de pont en silicium (70) comprend :
- la gravure de la zone de pont en silicium de telle sorte que deux porte-à-faux (10A, 10B) comprenant le au moins un porte-à-faux (10) soient formés lors de la libération d'au moins un porte-à-faux (10), dans lequel lesdits deux porte-à-faux (10A, 10B) sont séparés par ladite zone de pont en silicium (70).
